# EUROPÄISCHE PATENTSCHRIFT

(11) **EP 1 369 880 B1**
(45) Veröffentlichungstag und Bekanntmachung des Hinweises auf die Patenterteilung: **31.10.2007**
(21) Anmeldenummer: 03012626.2
(22) Anmeldetag: 03.06.2003
(51) Int. Cl.: H01G 4/40, H01G 4/38, H01G 4/12, H01C 7/10

(54) **Elektrisches Vielschichtbauelement und Schaltungsanordnung**
Electrical multilayer component and circuit arrangement
Composant électrique multicouche et circuit

(30) Priorität: 03.06.2002 DE 10224565
(43) Veröffentlichungstag der Anmeldung: 10.12.2003
(73) Patentinhaber: EPCOS AG, 81669 München (DE)
(72) Erfinder: Feichtinger, Thomas, 8010 Graz (AT); Krumphals, Robert, 8530 Deutschlandsberg (AT)
(74) Vertreter: Epping - Hermann - Fischer

(56) Entgegenhaltungen:
- DE-A- 19 639 947
- US-A- 5 880 925
- PATENT ABSTRACTS OF JAPAN Bd. 0180, Nr. 91 (E-1508), 15. Februar 1994 (1994-02-15) & JP 5 299292 A (MURATA MFG CO LTD), 12. November 1993 (1993-11-12)
- PATENT ABSTRACTS OF JAPAN Bd. 0182, Nr. 77 (E-1554), 26. Mai 1994 (1994-05-26) & JP 6 053077 A (MITSUBISHI MATERIALS CORP), 25. Februar 1994 (1994-02-25)
- PATENT ABSTRACTS OF JAPAN Bd. 0180, Nr. 22 (E-1490), 13. Januar 1994 (1994-01-13) & JP 5 259789 A (MURATA MFG CO LTD), 8. Oktober 1993 (1993-10-08)
- PATENT ABSTRACTS OF JAPAN Bd. 1998, Nr. 09, 31. Juli 1998 (1998-07-31) & JP 10 097954 A (TAIYO YUDEN CO LTD), 14. April 1998 (1998-04-14)

## Beschreibung

Die Erfindung betrifft ein elektrisches Vielschichtbauelement mit einem Grundkörper enthaltend einen Stapel aus übereinanderliegenden Dielektrikumsschichten mit dazwischenliegenden Elektrodenschichten.

Aus der Druckschrift DE 196 39 947 A1 ist ein Vielschichtbauelement der eingangs genannten Art bekannt, bei dem der Grundkörper zwei entlang einer Längsrichtung verlaufende, gegenüberliegende Seitenflächen und mindestens eine Stirnfläche aufweist. Es sind in Längsrichtung des Bauelements nebeneinander angeordnete Vielschichtkondensatoren gebildet. Die Vielschichtkondensatoren haben eine gemeinsame Gegenelektrode, die ihrerseits wieder aus einem Stapel von übereinanderliegenden Elektrodenschichten gebildet sein kann und welche auf der Stirnseite des Bauelements aus dem Bauelement herausgeführt ist. Ferner sind die Vielschichtkondensatoren jeweils mit einer Widerstandsstruktur verbunden, die auf der Oberseite des Bauelements angeordnet ist.

Das bekannte Bauelement hat den Nachteil, daß es eine relativ kleine Integrationsdichte aufweist, das heißt, daß nur sehr wenige Kondensatoren bezogen auf die von dem Grundkörper in Anspruch genommene Grundfläche in dem Bauelement integriert sind. Ferner hat das bekannte Bauelement den Nachteil, daß nur einfache Verschaltungen der Kondensatoren mit den Widerstandsstrukturen realisiert werden können.

Aus der Druckschrift JP 05-299292 ist ein Rauschfilter bekannt, das Elektrodenschichten, die jeweils mit an unterschiedlichen Seiteflächen des Bauelements angeordneten Außenkontakten kontaktiert sind, aufweist. Zwischen den Elektrodenschichten ist eine stirnseitig herausgeführte Masseelektrode angeordnet.

Es ist Aufgabe der vorliegenden Erfindung, ein elektrisches Vielschichtbauelement anzugeben, das eine hohe Integrationsdichte aufweist.

Diese Aufgabe wird gelöst durch ein elektrisches Vielschichtbauelement nach Patentanspruch 1. Vorteilhafte Ausgestaltungen sind den abhängigen Ansprüchen zu entnehmen.

Es wird ein elektrisches Vielschichtbauelement angegeben mit einem Grundkörper enthaltend einen Stapel aus übereinanderliegenden Dielektrikumsschichten. Zwischen Dielektrikumsschichten sind Elektrodenschichten angeordnet, welche elektrisch leitfähig sind. Der Grundkörper weist zwei entlang einer Längsrichtung verlaufende, gegenüberliegende Seitenflächen und mindestens eine Stirnfläche auf.

Ferner weist das Bauelement mehrere Vielschichtkondensatoren auf. Dabei weist es einen ersten Vielschichtkondensator auf, dessen erster elektrischer Kontakt auf der ersten Seitenfläche liegt und dessen zweiter elektrischer Gegenkontakt auf einer Stirnfläche liegt. Auch weist das Bauelement noch einen zweiten Vielschichtkondensator auf, dessen erster elektrischer Kontakt auf der zweiten Seitenfläche angeordnet ist und dessen zweiter elektrischer Gegenkontakt auf einer Stirnfläche des Grundkörpers angeordnet ist.

Der zweite elektrische Gegenkontakt ist vorzugsweise dem ersten elektrischen Kontakt gegenüberliegend angeordnet.

Es ist vorgesehen, dass jeder Vielschichtkondensator mehrere mit seinem ersten elektrischen Kontakt kontaktierte, übereinander angeordnete Elektrodenschichten aufweist.

Auch ist es vorgesehen, dass zumindest zwei der mehreren Vielschichtkondensatoren in Längsrichtung nebeneinander angeordnet sind.

In einer vorteilhaften Ausführungsform kann die Widerstandsstruktur mittels Siebdrucken einer Siebdruckpaste hergestellt sein.

Die Widerstandsstruktur kann geeignete Materialien, wie beispielsweise RuO₂, Bi₂Ru₂O₇, C, Ti₂N oder LaB₆ enthalten. Diese Materialien ermöglichen die Einstellung sowohl großer als auch kleiner Widerstandswerte für die Widerstandsstruktur. Die Widerstandsstruktur kann ferner Ag, Pd, Pt, Cu, Ni oder eine Legierung aus Ag und Pd oder aus Ag und Pt enthalten bzw. aus einem oder mehreren der genannten Materialien bestehen. Diese Materialien sind insbesondere zur Einstellung sehr kleiner Widerstandswerte geeignet.

Es können mehrere Widerstandsstrukturen in dem Bauelement enthalten sein, die Widerstände realisieren die gleich groß sind oder aber auch die Widerstände realisieren, welche verschieden große Werte aufweisen.

Eine Widerstandsstruktur kann in einer vorteilhaften Ausführungsform gegenüberliegende Kontakte miteinander verbinden. Dadurch wird das Bauelement kompakt, da Überschneidungen verschiedener Widerstandsstrukturen so vermieden werden können.

Die Widerstandsstruktur kann geradlinig verlaufen oder auch mäanderförmig, je nachdem, welcher Widerstandswert eingestellt werden soll.

Besonders vorteilhaft ist darüber hinaus ein Vielschichtbauelement enthaltend mehrere Vielschichtkondensatoren, bei dem jeweils gegenüberliegende Vielschichtkondensatoren mit jeweils einer Widerstandsstruktur eine Anzahl Π-Filter bilden. Zudem kann das Vielschichtbauelement vorteilhaft Dielektrikumsschichten aus einer Varistorkeramik enthalten. Dadurch kann eine Anordnung von zwei Π-Filtern gebildet werden, welche zusätzlich einen Varistoreffekt aufweisen und welche alle zusammen in einem einzigen Bauelement integriert sind.

Es wird ferner eine Schaltungsanordnung mit dem Vielschichtbauelement angegeben, wobei ein Gerät, das wenigstens zwei Zuleitungen aufweist, mit dem Vielschichtbauelement verbunden ist. Diese Verbindung ist so gestaltet, daß jede Zuleitung an ein Π-Filter angeschlossen ist. Dadurch wird die Ableitung hochfrequenter Störungen in jeder Zuleitung zu einer Erde ermöglicht, welche an einer Stirnfläche des Vielschichtbauelements anschließbar ist.

Diese Schaltungsanordnung hat den Vorteil, daß mit einem einzigen Bauelement zwei Zuleitungen zu einem störungsempfindlichen Gerät entstört werden können. Die Störungen werden über die Π-Filter zur Erde abgeleitet. Für den Fall, daß das Vielschichtbauelement zusätzlich Varistorkeramik enthält, können sogar zwei Entstörungsmechanismen in das einzige Bauelement integriert werden. Der erste Entstörungsmechanismus betrifft die hochfrequenten Signale, die als Rauschen das Nutzsignal überlagern. Mittels des Varistoreffekts können zusätzlich noch elektrostatische Entladungen (bekannt auch unter engl. ESD = electrostatic discharge) gegen Erde abgeleitet werden, womit ein umfassender Schutz des störungsempfindlichen Geräts realisiert werden kann.

Das Vielschichtbauelement hat gegenüber den bekannten Vielschichtbauelementen ferner den Vorteil, daß es eine um den Faktor zwei höhere Integrationsdichte aufweist, da entlang einer Längsrichtung des Bauelements immer zwei einander gegenüberliegende Kondensatoren in das Bauelement integriert sind.

Das Vielschichtbauelement hat ferner den Vorteil, daß mit Hilfe der stirnflächenseitig aus dem Grundkörper herausgeführten Kontakte eine interne Verschaltung mehrerer Vielschichtkondensatoren realisiert werden kann. Dadurch reduziert sich der später auf der mit dem Vielschichtbauelement zu bestückenden Platine der Verschaltungs- und Verdrahtungaufwand, was wiederum Platz auf der Platine einspart.

In einer Ausführungsform ist im Grundkörper ein erster Stapel von übereinanderliegenden Elektrodenschichten angeordnet, die an einem ersten Kontakt auf einer ersten Seitenfläche aus dem Grundkörper herausgeführt sind. Dieser erste Stapel bildet zusammen mit einem weiteren Stapel aus übereinanderliegenden Elektrodenschichten, die auf einer Stirnfläche aus dem Grundkörper herausgeführt sind, einen ersten Vielschichtkondensator.

Es ist ferner im Grundkörper ein zweiter Stapel von übereinanderliegenden Elektrodenschichten angeordnet, die an einem zweiten Kontakt aus dem Grundkörper herausgeführt sind. Der zweite Kontakt auf der zweiten Seitenfläche des Grundkörpers angeordnet. Der zweite Stapel bildet zusammen mit einem Stapel von Elektrodenschichten, die auf einer Stirnfläche aus dem Grundkörper herausgeführt sind, einen zweiten Vielschichtkondensator.

Zur weiteren Erhöhung der Integrationsdichte ist es vorteilhaft, wenn weitere Vielschichtkondensatoren gebildet sind. Diese weiteren Vielschichtkondensator können vorteilhafterweise entlang der gegenüberliegenden Seitenflächen angeordnet sein, wobei die Kontakte jeweils auf gegenüberliegenden Seitenflächen liegen. Die zweiten Kontakte der weiteren Vielschichtkondensatoren können auf einer Stirnfläche des Grundkörpers liegen. Vorteilhafterweise sind die weiteren Vielschichtkondensatoren gebildet aus weiteren Stapeln von übereinanderliegenden Elektrodenschichten. Die weiteren Stapel sind dabei neben dem ersten beziehungsweise neben dem zweiten Stapel von Elektrodenschichten angeordnet und die Elektrodenschichten dieser Stapel sind wiederum auf gegenüberliegenden Seitenflächen des Grundkörpers aus diesem herausgeführt.

Desweiteren ist es vorteilhaft, wenn der zweite Kontakt eines Vielschichtkondensators von beiden Stirnflächen her kontaktiert werden kann. Dadurch können besondere Schaltungsvarianten realisiert werden, wobei ein Vielschichtkondensator von beiden Seiten her kontaktiert werden kann, beispielsweise zur Bildung einer gemeinsamen Erde mit weiteren Vielschichtkondensatoren.

In einer Ausführungsform der Erfindung ist jeder im Vielschichtbauelement enthaltene Vielschichtkondensator gebildet mittels eines Stapels von Elektrodenschichten, die beiderseits auf zwei gegenüberliegenden Stirnseiten des Grundkörpers herausgeführt sind.

Diese Ausführungsform hat den Vorteil, daß ein Kondensatoranschluß, der allen Kondensatoren gemeinsam ist in Richtung des Grundkörpers durch das Vielschichtbauelement durchgeführt werden kann, was wiederum den Aufwand für die äußere Beschaltung des Vielschichtbauelements reduziert.

Weiterhin ist es vorteilhaft, wenn zwei Vielschichtkondensatoren Kontakte aufweisen, die auf gegenüberliegenden Stirnflächen liegen, wodurch beispielsweise eine Erdung nebeneinander liegender Kondensatoren mit einer Stirnfläche und gleichzeitig eine Erdung der auf der gegenüberliegenden Seite angeordneten Vielschichtkondensatoren mit der gegenüberliegenden Stirnfläche möglich wird.

In einer weiteren Ausführungsform der Erfindung weist der Grundkörper zwei verschiedene Stapel von übereinanderliegenden Elektrodenschichten auf, die auf gegenüberliegenden Stirnseiten aus dem Grundkörper herausgeführt sind. Die beiden Stapel sind elektrisch gegeneinander isoliert. Mit Hilfe dieser Ausführungsform gelingt es, im Vielschichtbauelement integrierte Vielschichtkondensatoren zu Gruppen zusammenzufassen, die jeweils über einen gemeinsamen Kontakt intern miteinander verschaltet sind.

Beispielsweise können diejenigen Vielschichtkondensatoren einen gemeinsamen Kontakt aufweisen, welche entlang einer Seitenfläche nebeneinander angeordnet sind. Dann enthalten entlang einer Seitenfläche nebeneinander angeordnete Vielschichtkondensatoren einen Stapel von übereinanderliegenden Elektrodenschichten, die nur auf einer Stirnseite aus dem Grundkörper herausgeführt sind.

Ebenso können auch die entlang der gegenüberliegenden Seitenfläche nebeneinander angeordneten Vielschichtkondensatoren einen Stapel von übereinanderliegenden Elektrodenschichten enthalten, die nur auf der gegenüberliegenden Stirnfläche aus dem Grundkörper herausgeführt sind.

Die entlang jeweils einer Seitenfläche angeordneten Vielschichtkondensatoren können jeweils die gleiche Kapazität aufweisen. In einer anderen Ausführungsform der Erfindung können die Vielschichtkondensatoren auch unterschiedliche Kapazitäten aufweisen. Falls einander gegenüberliegende Kondensatoren die gleiche Kapazität aufweisen, ist es möglich, ein symmetrisches Bauelement zu realisieren.

In einer anderen Ausführungsform der Erfindung weisen die entlang der ersten Seitenfläche angeordneten Vielschichtkondensatoren eine größere Kapazität auf, als die entlang der zweiten Seitenfläche angeordneten Vielschichtkapazitäten. In einer anderen Ausführungsform der Erfindung steigt die Kapazität von entlang einer Seitenfläche angeordneten Kondensatoren in Längsrichtung des Grundkörpers monoton an oder sie fällt monoton ab.

In einer besonderen Ausführungsform der Erfindung enthalten die Dielektrikumsschichten ein Keramikmaterial mit Varistoreffekt. In Betracht kommen beispielsweise Keramikmaterialien, die ZnO-Bi oder ZnO-Pr enthalten. Solche Dielektrikumsschichten haben den Vorteil, daß sie neben dem Kondensator noch als weiteres Bauelement einen Varistor in das Vielschichtbauelement integrieren.

In einer anderen Ausführungsform der Erfindung können die Dielektrikumsschichten eine Kondensatorkeramik auf der Basis von Bariumtitanat enthalten. Als Dielektrikumsschicht kommt beispielsweise eine sogenannte "C0G"-Keramik in Betracht. Ein solches Material wäre beispielsweise eine (Sm, Pa) NdCiO₃-Keramik. Es kommt aber auch eine "X7R"-Keramik in Betracht, beispielsweise dotiertes Bariumtitanat.

Der Grundkörper kann eine Grundfläche aufweisen, die kleiner als 2,5 mm² ist und dabei mindestens vier Vielschichtkondensatoren und mindestens zwei Widerstandsstrukturen enthalten.

Es ist auch möglich, den Grundkörper so auszubilden, daß seine Grundfläche eine Fläche von maximal 5,2 mm² mißt. Dann enthält das Vielschichtbauelement mindestens acht Vielschichtkondensatoren und mindestens vier Widerstandsstrukturen.

Es ist darüber hinaus auch möglich, die Grundfläche des Grundkörpers so auszubilden, daß sie kleiner als 8 mm² ist. Dann können mindestens acht, zehn oder sogar zwölf Vielschichtkondensatoren und mindestens vier Widerstandsstrukturen in das Bauelement integriert werden.

Im folgenden wird die Erfindung anhand von Ausführungsbeispielen und den dazugehörigen Figuren näher erläutert.
- Figur 1: zeigt einen Längsschnitt durch ein beispielhaftes elektrisches Vielschichtbauelement in einer schematischen, nicht maßstabsgetreuen Darstellung.
- Figur 2: zeigt einen Querschnitt entlang der Linie II-II des Bauelement aus Figur 1.
- Figur 3: zeigt ein Ersatzschaltbild für das Bauelement aus Figur 1.
- Figur 4: zeigt ein weiteres beispielhaftes elektrisches Vielschichtbauelement in einem schematischen Längsschnitt.
- Figur 5: zeigt einen Querschnitt durch das Bauelement aus Figur 4 entlang der Linie V-V.
- Figur 6: zeigt ein weiteres beispielhaftes elektrisches Vielschichtbauelement in einem schematischen Längsschnitt.
- Figur 7: zeigt einen Querschnitt des Bauelements aus Figur 6 entlang der Linie VII-VII.
- Figur 8: zeigt beispielhaft ein weiteres elektrisches Vielschichtbauelement in einem schematischen Längsschnitt.
- Figur 9: zeigt einen Querschnitt durch das Bauelement aus Figur 8 entlang der Linie IX-IX.
- Figur 10: zeigt ein weiteres beispielhaftes elektrisches Vielschichtbauelement in einem schematischen Längsschnitt.
- Figur 11: zeigt einen Querschnitt durch das Bauelement aus Figur 10 entlang der Linie XI-XI.
- Figur 12: zeigt ein weiteres elektrisches Vielschichtbauelement in einem schematischen Längsschnitt.
- Figur 13: zeigt ein weiteres beispielhaftes elektrisches Vielschichtbauelement in einem schematischen Längsschnitt.
- Figur 14: zeigt ein Ersatzschaltbild für ein elektrisches Vielschichtbauelement gemäß Figur 13 für den Fall, daß für die Dielektrikumsschichten eine Varistorkeramik verwendet wird.
- Figur 15: zeigt beispielhaft einen Längsschnitt durch ein elektrisches Vielschichtbauelement in einer schematischen nicht maßstabsgetreuen Darstellung.
- Figur 16: zeigt ein Ersatzschaltbild zusammen mit der Zuordnung der Kontakte für das Bauelement nach Figur 15.
- Figur 17: zeigt ein weiteres Bauelement in einer Ansicht entsprechend der Ansicht von Figur 15.
- Figur 18: zeigt eine Schaltungsanordnung mit dem Bauelement.

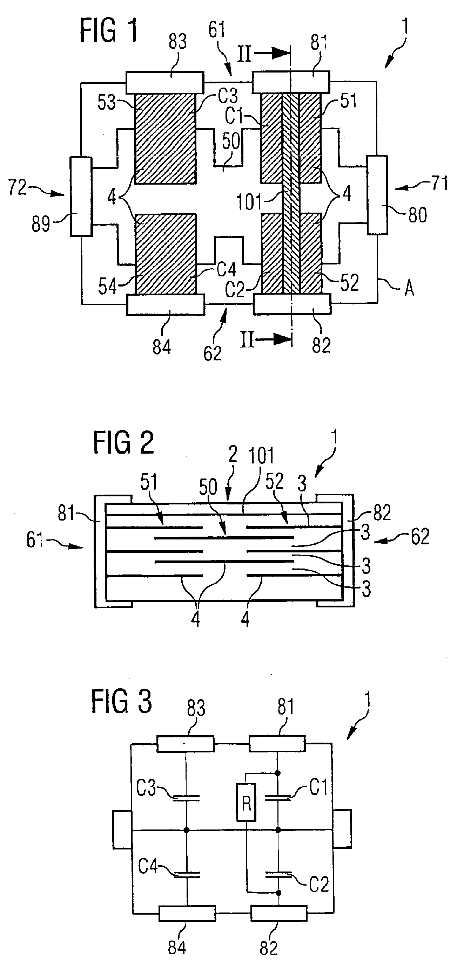

Figur 1 zeigt den Grundkörper 1 eines elektrischen Vielschichtbauelements. Das Bauelement ist dabei längs durchgeschnitten und es ist die Draufsicht auf Elektrodenschichten 4 zu sehen, die teils in einer Ebene liegen (markiert mit 51, 52, 53, 54) beziehungsweise teils in einer darunterliegenden, im wesentlichen parallelen Ebene angeordnet sind (markiert mit 50). Die Elektrodenschichten 4 können z. B. aus Ag, Pd, Pt oder auch aus einer Legierung aus Ag und Pt bzw. aus Ag und Pd bestehen bzw. solche Metalle enthalten. Sie können aber auch Cu oder Ni enthalten.

Es sind Stapel 50, 51, 52, 53, 54 von übereinanderliegenden Elektrodenschichten 4 in einer Draufsicht gezeigt. Die Elektrodenschichten 4 des Stapels 51 sind an der ersten Seitenfläche 61 am ersten Kontakt 81 aus dem Grundkörper 1 herausgeführt. Der Grundkörper 1 weist eine Grundfläche A auf. Die Elektrodenschichten 4 des Stapels 52 sind an einem Kontakt 82 auf der der Seitenfläche 61 gegenüberliegenden Seitenfläche 62 aus dem Grundkörper 1 herausgeführt. Dadurch sind einander gegenüberliegende Vielschichtkondensatoren C1, C2 realisiert. Die Gegenelektroden der Vielschichtkondensatoren C1 C2 werden dabei gebildet durch Elektrodenschichten 4, welche als Stapel 50 übereinanderliegen und welche zu beiden Seiten auf jeder Stirnseite 71, 72 aus dem Grundkörper 1 des Bauelements herausgeführt sind. Die Elektrodenschichten 4 des Stapels 50 sind dabei mit auf den Stirnflächen 71, 72 angeordneten Kontakten 80, 89 elektrisch kontaktiert. Es sind in Längsrichtung neben den Vielschichtkondensatoren C1 und C2 noch die Vielschichtkondensatoren C3 beziehungsweise C4 angeordnet. Die Vielschichtkondensatoren C3 und C4 sind ebenso wie die Vielschichtkondensatoren C1 und C2 gebildet aus Stapeln 53, 54 von übereinanderliegenden Elektrodenschichten 4, die jeweils auf gegenüberliegenden Seitenflächen 61, 62 aus dem Grundkörper 1 herausgeführt sind. Im einzelnen sind die Elektrodenschichten 4 des Stapels 53 mit dem Kontakt 83 auf der ersten Seitenfläche 61 des Grundkörpers 1 kontaktiert. Die Elektrodenschichten 4 des Stapels 54 sind mit dem Kontakt 84 auf der der ersten Seitenfläche 61 gegenüberliegenden Seitenfläche 62 verbunden. Indem die Elektrodenschichten 4 des Schichtstapels 50 eine gemeinsame Gegenelektrode für alle Vielschichtkondensatoren C1 C2, C3, C4 bilden, kann ein Bauelement realisiert werden, für das das in Figur 3 gezeigte Ersatzschaltbild gilt. Die Vielschichtkondensatoren sind also bereits intern miteinander verschaltet.

Desweiteren ist eine Widerstandsstruktur 101 vorgesehen, die aus Siebdruckpaste gebildet im Innern des Grundkörpers 1 verläuft und die die Kontakte 81, 82 miteinander verbindet.

Die Seitenflächen 61, 62 verlaufen entlang einer Längsrichtung. Die Längsrichtung ist durch den Pfeil angegeben.

In Figur 2 sind die Schichtstapel 50, 51, 52 in einem Querschnitt zu sehen. Die Elektrodenschichten 4 sind dabei zwischen Dielektrikumsschichten 3 angeordnet. Das erfindungsgemäße Vielschichtbauelement kann vorteilhafterweise hergestellt werden durch Übereinanderstapeln von keramischen Grünfolien und geeigneten Elektrodenschichten, anschließendem Verpressen und Sintern des Schichtstapels. Durch Gemeinsamsinterung wird sowohl eine hohe mechanische Stabilität als auch gute elektrische Eigenschaften realisiert. Die Außenkontakte 81, 82 können beispielsweise mittels Silbereinbrennpaste an den Außenflächen des Grundkörpers 1 realisiert werden. Indem die Kontakte 81, 82 kappenartig über die Seitenflächen 61, 62 greifen, kann ein SMD-fähiges Bauelement realisiert werden. Aus Figur 2 geht auch hervor, daß die Elektrodenschichten 4 der Schichtstapel 51 und 52 innerhalb des Bauelements elektrisch voneinander isoliert sind. Daher werden zwei verschiedene Vielschichtkondensatoren durch die Schichtstapel 51, 52 gebildet.

Ferner ist aus Figur 2 auch die Widerstandsstruktur 101 ersichtlich.

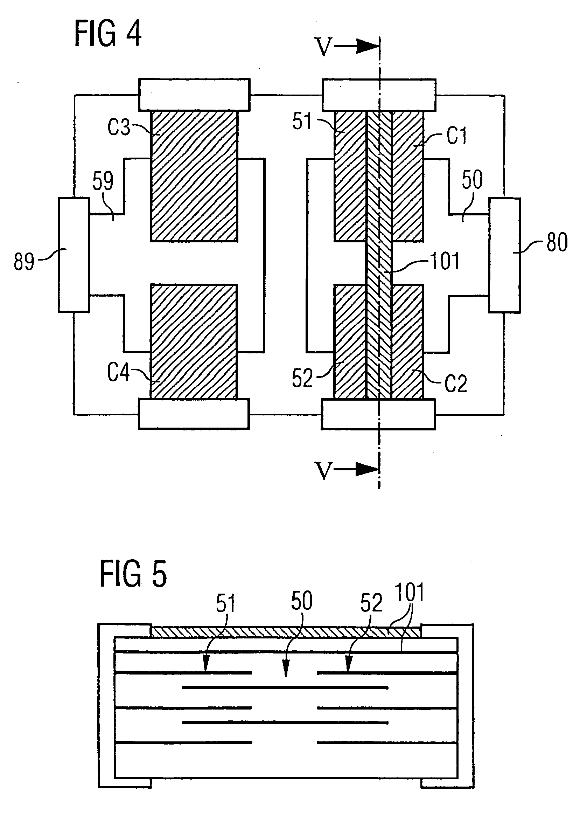

Figur 4 zeigt ein elektrisches Vielschichtbauelement entsprechend Figur 1, jedoch mit dem Unterschied, daß die als Gegenelektrode ausgeführten Elektrodenschichten in zwei verschiedenen Schichtstapeln 50, 59 angeordnet sind. Die Elektrodenschichten des Schichtstapels 50 sind dabei auf der ersten Stirnfläche mit einem Kontakt 80 aus dem Grundkörper herausgeführt. Die Elektrodenschichten des zweiten Schichtstapels 59 sind auf der gegenüberliegenden Stirnfläche mit Hilfe des Kontakts 89 aus dem Grundkörper herausgeführt. In Längsrichtung des Bauelements sind die Elektrodenschichten der Stapel 50 und 59 innerhalb des Bauelements elektrisch voneinander isoliert.

Indem die Vielschichtkondensatoren C1, C2, C3, C4 mit Hilfe von verschiedenen Stapeln 50, 59 aus Elektrodenschichten gebildet werden, kann eine von Figur 3 verschiedene Verschaltung der Vielschichtkondensatoren C1 C2, C3, C4 realisiert werden, was je nach Anwendungsfall zweckmäßig ist.

Ferner ist aus Figur 4 ersichtlich, daß die Widerstandsstruktur 101 innerhalb des Grundkörpers verlaufen kann (untere Position). Die Widerstandsstruktur 101 kann aber auch auf der Oberseite des Bauelements als Verbindung zwischen den beiden äußeren Kontakten angeordnet sein.

Figur 5 zeigt den Querschnitt von Figur 4 in analoger Weise zu Figur 2. Es sind die Stapel 50, 51, 52 von übereinanderliegenden Elektrodenschichten dargestellt.

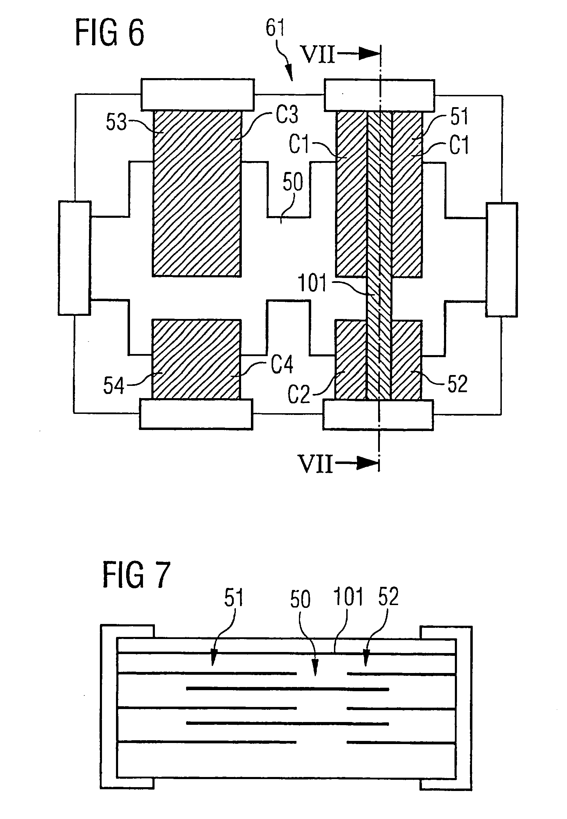

Figur 6 zeigt ein Vielschichtbauelement entsprechend Figur 1 mit dem Unterschied, daß die Elektrodenschichten der Schichtstapel 51, 53 in der Fläche größer ausgeführt sind, als die analogen Schichtstapel in Figur 1. Demgegenüber sind die Elektrodenschichten der Schichtstapel 52 und 54 kleiner ausgeführt als die entsprechenden Elektrodenschichten in Figur 1. Dadurch kann es erreicht werden, daß die Vielschichtkondensatoren C1 und C3 eine größere Kapazität aufweisen, als die Vielschichtkondensatoren C2 und C4, was je nach Anwendungsfall für das Vielschichtbauelement von Vorteil ist.

Figur 7 zeigt den Querschnitt zu Figur 6, wobei die Stapel 50, 51, 52 dargestellt sind.

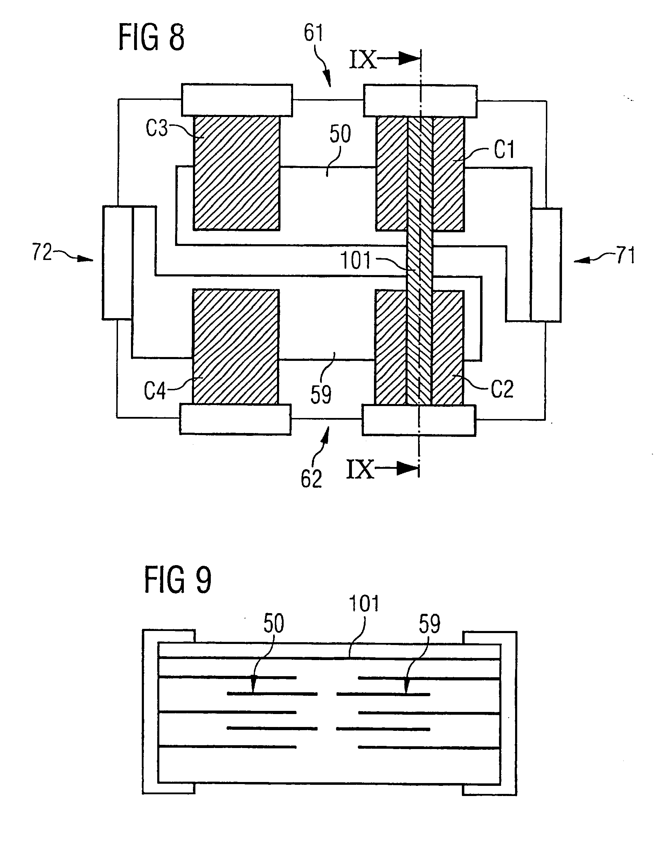

Figur 8 zeigt ein Vielschichtbauelement entsprechend Figur 4 mit dem Unterschied, daß die mit dem gemeinsamen Schichtstapel 50 gebildeten Vielschichtkondensatoren C1 C3 nicht einander gegenüberliegend sondern entlang einer ersten Seitenfläche 61 nebeneinander angeordnet sind. Dementsprechend sind die mit dem Schichtstapel 59 gebildeten Vielschichtkondensatoren C2 und C4 entlang der zweiten Seitenfläche 62 nebeneinander angeordnet. Dies wird realisiert, indem entsprechend gestaltete Vielschichtelektroden einen Stapel 50 bilden, wobei die Elektrodenschichten an der ersten Stirnfläche 71 aus dem Grundkörper 1 herausgeführt sind. In analoger Weise sind Elektrodenschichten, die einen Stapel 59 von Elektrodenschichten bilden, auf der gegenüberliegenden Stirnfläche 72 aus dem Grundkörper 1 herausgeführt. Die Elektrodenschichten der Stapel 50 und 59 sind innerhalb des Vielschichtbauelements allseitig gegeneinander isoliert. Dies geht auch hervor aus Figur 9, welche einen entsprechenden Querschnitt zeigt, und wo zu erkennen ist, daß die Elektrodenschichten der Stapel 50 und 59 voneinander isoliert sind, das heißt, daß die Elektrodenschichten in der Mitte des Bauelements unterbrochen sind.

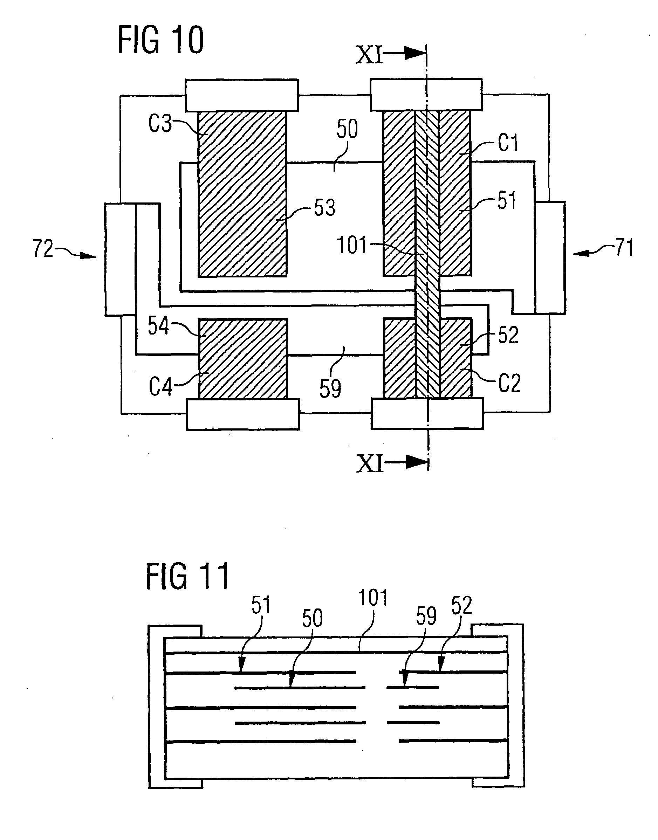

Figur 10 zeigt ein Vielschichtbauelement entsprechend Figur 8, mit dem Unterschied, daß die Elektrodenschichten der Stapel 51 und 53 größer ausgeführt sind, als die entsprechenden Elektrodenschichten in Figur 8. Weiterhin sind die Elektrodenschichten der Stapel 52 und 54 kleiner ausgeführt als die entsprechenden Elektrodenschichten in Figur 8. Dadurch wird es erreicht, ein Vielschichtbauelement zu realisieren, bei dem die Kapazitäten der Vielschichtkondensatoren C1 und C3 größer sind als die Kapazitäten der Vielschichtkondensatoren C2 und C4.

Figur 11 zeigt entsprechend Figur 9 wieder den dazugehörigen Querschnitt.

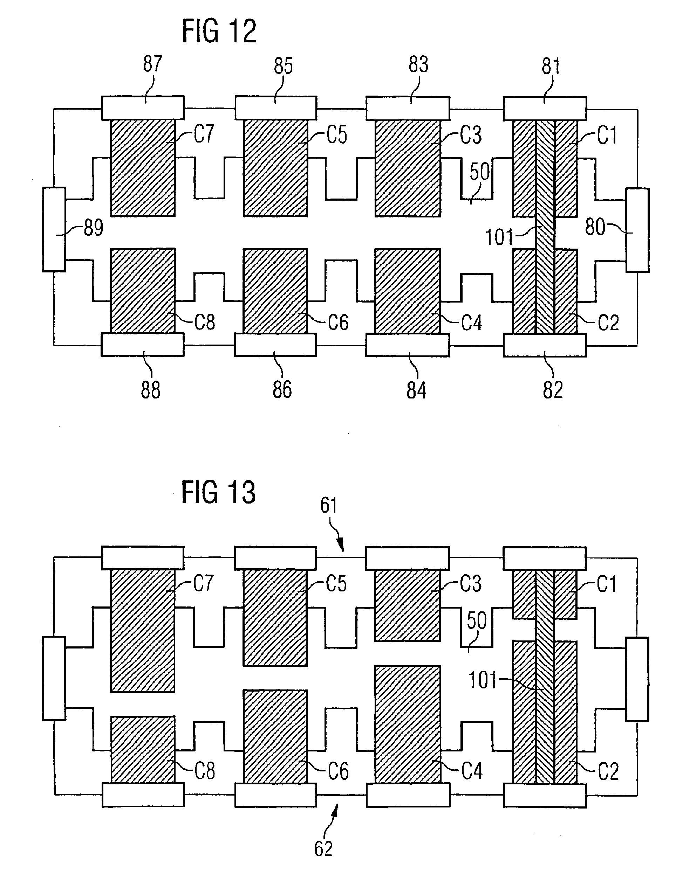

Figur 12 zeigt ein weiteres Vielschichtbauelement, das entsprechend Figur 1 ausgeführt ist, jedoch mit dem Unterschied, daß nicht vier Vielschichtkondensatoren sondern acht Vielschichtkondensatoren C1, C2, C3, C4, C5, C6, C7, C8 innerhalb des Bauelements angeordnet sind. Die Vielschichtkondensatoren C1 bis C8 sind mit entsprechenden Kontakten 81, 82, 83, 84, 85, 86, 87, 88 an den Außenflächen des Grundkörpers verbunden. Die Kondensatoren C1 bis C8 sind gebildet mit Hilfe eines Stapels 50 von übereinanderliegenden Elektrodenschichten, die allen Vielschichtkondensatoren C1 bis C8 gemeinsam sind. Die Elektrodenschichten des Stapels 50 sind auf beiden einander gegenüberliegenden Stirnseiten des Grundkörpers 1 mit Kontakten 80, 89 aus diesem herausgeführt.

Figur 13 zeigt ein Vielschichtbauelement entsprechend Figur 12 mit dem Unterschied, daß die Kapazität der Vielschichtkondensatoren C7, C5, C3, C1 in dieser Reihenfolge stetig abnimmt. Entsprechend nimmt die Kapazität der Vielschichtkondensatoren C8, C6, C4, C2 in Längsrichtung des Bauelements zu.

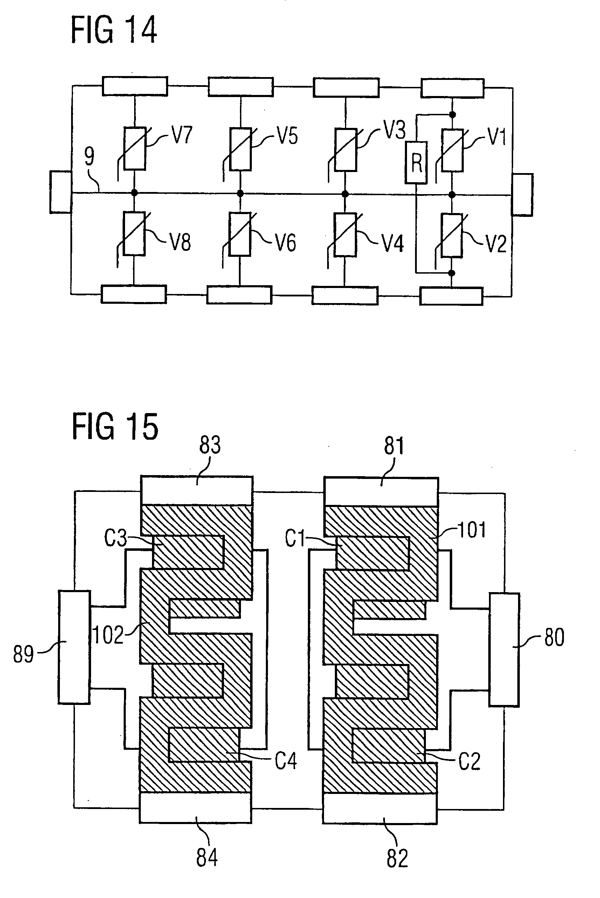

Figur 14 zeigt ein Ersatzschaltbild für ein Vielschichtbauelement nach Figur 12 für den Fall, daß für die Dielektrikumsschichten eine Varistorkeramik verwendet wird. Dann entsteht gemäß Figur 14 ein Bauelement mit Varistoren V1, V2, V3, V4, V5, V6, V7, V8, welche durch eine gemeinsame Mittelelektrode 9 miteinander verschaltet sind.

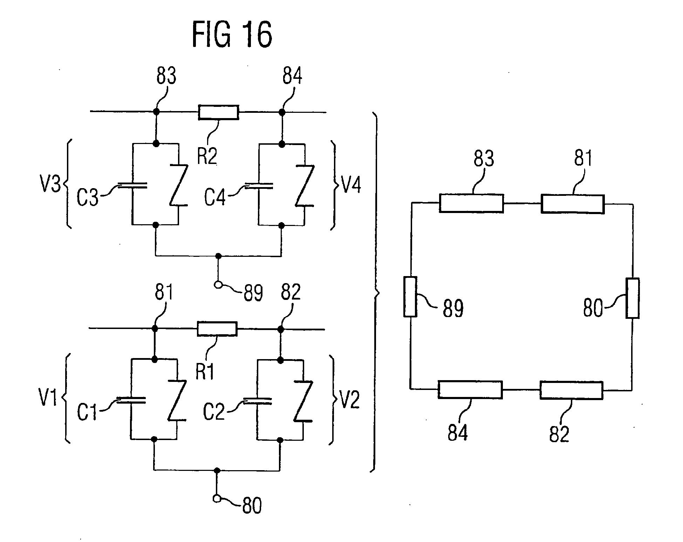

Figur 15 zeigt eine Ansicht eines Bauelements entsprechend Figur 1. Zusätzlich sind dargestellt zwei Widerstandsstrukturen 101, 102, die mäanderförmig zwischen den Kontakten 81, 82 beziehungsweise 83, 84 verlaufen. Unter Verwendung einer Varistorkeramik für die Dielektrikumsschichten des Bauelements aus Figur 15 können die in Figur 16 unter Bezugnahme auf die Außenkontakte 80, 81, 82, 83, 84, 89 im rechten Teil der Figur 16 dargestellten Π-Filter realisiert werden. Dabei sind jeweils die Kontakte 83, 84 verbunden durch den Widerstand R2, die Kontakte 81, 82 sind verbunden durch den Widerstand R1. Die Widerstände R1, R2 sind gebildet durch die Widerstandsstrukturen 101, 102. Ferner sind die Kontakte 83, 84 beziehungsweise die Kontakte 81, 82 durch parallel geschaltete Vielschichtvaristoren V3, V4 beziehungsweise V1, V2 mit den jeweiligen an der Stirnseite angeordneten Kontakten 80, 89 verbunden. Die Vielschichtvaristoren V1, V2, V3, V4 bilden dabei einerseits eine Kapazität C1, C2, C3, C4, die aus den dielektrischen Eigenschaften der Varistorkeramik resultiert. Darüber hinaus ist parallel zu der jeweiligen Kapazität C1 C2, C3, C4 eine bidirektionale Z-Diode dargestellt, die den reinen Varistoreffekt repräsentiert.

Für die Kapazitäten aller hier beschriebenen Bauelemente kommen insbesondere Werte zwischen 3 und 300 pF in Betracht. Für die Widerstände in den hier beschriebenen Bauelementen kommen Werte zwischen 0,1 und 100 Ohm in Betracht.

Für das in Figur 15 und Figur 16 beschriebene Ausführungsbeispiel gelten folgende Werte:
C1 = C3 = 30 pF
C2 = C4 = 60 pF
R1 = R2 = 2 Ohm

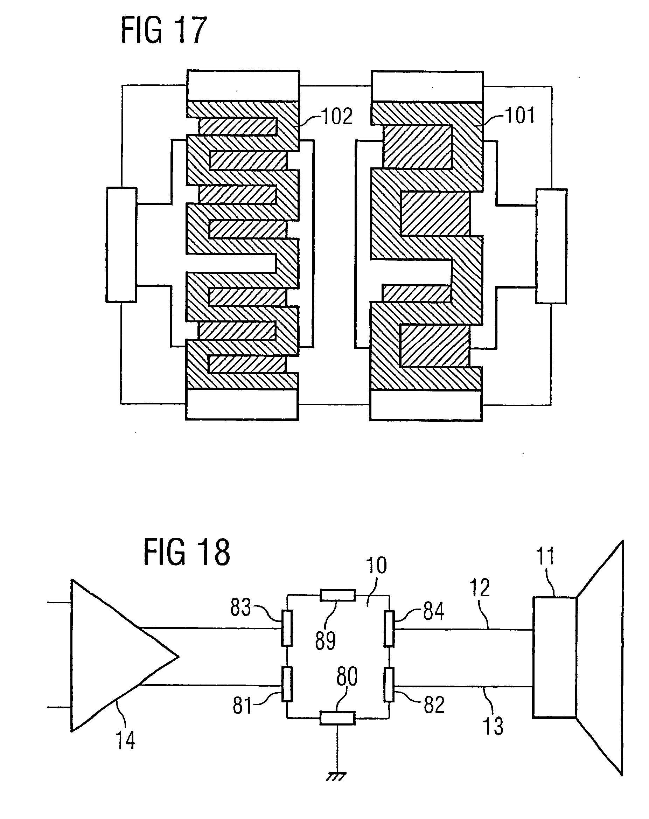

Figur 17 zeigt ein weiteres Ausführungsbeispiel entsprechend Figur 15 mit dem Unterschied, daß die Widerstandsstrukturen 101, 102 unterschiedliche Länge und somit einen unterschiedlichen Wert des elektrischen Widerstands aufweisen.

Es wird in diesem Zusammenhang darauf hingewiesen, daß die in den Figuren 1 bis 17 gezeigten Variationen für die Schichten der Schichtstapel 50, 59, die Variationen für die Schichtstapel 51 bis 58 sowie die Variationen bezüglich der Widerstandsstrukturen 101, 102 miteinander kombiniert werden können und die Erfindung nicht auf die einzelnen Ausführungsbeispiele beschränkt ist.

Figur 18 zeigt eine Schaltung mit dem Vielschichtbauelement 10, wobei ein Verstärker 14 verbunden ist mit einem störungsempfindlichen Gerät 11, welches beispielsweise ein Lautsprecher sein kann. Verstärker 14 und Gerät 11 sind verbunden über Zuleitungen 12, 13. In die Zuleitungen 12, 13 ist ein Bauelement 10 geschaltet, das dem Bauelement wie es in Figur 15 beziehungsweise in Figur 16 dargestellt ist, entspricht. Auch die Anschlüsse der Zuleitungen 12, 13 sind durch die Bezugnahmen auf die Kontakte 81, 82, 83, 84, 80, 89 in Figur 16 definiert. Der Kontakt 80 ist mit der Erde verbunden. Sowohl hochfrequente Störungen, wie sie beispielsweise in Mobilfunkgeräten über die Trägerfrequenz von einigen 100 bis 1000 MHz auftreten, als auch elektrostatische Entladungen, welche kurzzeitige Pulse mit hohen Spannungen generieren, können durch das Bauelement 10 sicher vor dem Gerät 11 zur Erde abgeleitet werden, wobei die Nutzsignale, im Beispiel aus Figur 18 Sprachsignale mit einigen kHz, ungehindert vom Verstärker 14 zum Gerät 11 durchlaufen können.

Durch Verwenden eines geeigneten Keramikmaterials für die Dielektrikumsschichten wird aus dem Vielschichtkondensator ein Vielschichtvaristor. Ebenso können durch Auswahl geeigneter Keramikmaterialien für die Dielektrikumsschichten noch weitere Vielschichtbauelemente realisiert werden, so daß die vorliegende Erfindung nicht beschränkt ist auf Vielschichtkondensatoren im strengen Sinne, sondern lediglich darauf, daß ein keramisches Vielschichtbauelement nach der Bauweise der Vielschichtkondensatoren, das heißt also durch kammartig ineinandergreifende flächenartige Elektrodenstrukturen gebildet ist.

### Bezugszeichenliste

- 1: Grundkörper
- 2: Stapel
- 3: Dielektrikumsschicht
- 4: Elektrodenschicht
- 50, 51, 52, 53, 54, 55, 56, 57, 58, 59: Stapel
- 61, 62: Seitenfläche
- 71, 72: Stirnfläche
- 80, 81, 82, 83, 84, 85, 86, 87, 88, 89: Kontakt
- C1 C2, C3, C4, C5, C6, C7, C8: Vielschichtkondensator
- V1, V2, V3, V4, V5, V6, V7, V8: Vielschichtvaristor
- A: Grundfläche
- 9: Mittelelektrode
- R1, R2: Widerstand
- 101, 102: Widerstandsstruktur
- 10: Bauelement
- 11: Gerät
- 12, 13: Zuleitung
- 14: Verstärker

## Patentansprüche

1. Vielschichtbauelement
- mit einem Grundkörper (1) enthaltend einen Stapel (2) aus übereinander liegenden Dielektrikumsschichten (3) mit dazwischenliegenden Elektrodenschichten (4),
- bei dem der Grundkörper (1) entlang einer Längsrichtung verlaufende, gegenüberliegende Seitenflächen (61, 62) und Stirnflächen (71, 72) aufweist,
- in das eine Widerstandsstruktur (101, 102) integriert ist,
- mit mehreren Vielschichtkondensatoren (C1, C2, C3, C4, C5, C6, C7, C8), wobei
- ein erster elektrischer Kontakt (81) eines jeden Vielschichtkondensators auf einer Seitenfläche (61) des Vielschichtbauelements, und
- ein zweiter elektrischer Gegenkontakt (80) eines jeden Vielschichtkondensators auf einer Stirnfläche (71, 72) des Vielschichtbauelements angeordnet ist, und
- die ersten elektrischen Kontakte von zumindest zwei Vielschichtkondensatoren auf gegenüberliegenden Seitenflächen angeordnet sind, und
- jeder Vielschichtkondensator mehrere mit seinem ersten elektrischen Kontakt kontaktierte, übereinander angeordnete Elektrodenschichten aufweist, und
- zumindest zwei der Vielschichtkondensatoren in Längsrichtung nebeneinander angeordnet sind.

2. Vielschichtbauelement nach Anspruch 1, bei dem zumindest zwei der Vielschichtkondensatoren (C1, C2, C3, C4, C5, C6, C7, C8) sich in Querrichtung gegenüberliegen.

3. Vielschichtbauelement nach einem der Ansprüche 1 oder 2, bei dem die Elektrodenschichten (4) benachbarter Vielschichtkondensatoren (C1, C2, C3, C4, C5, C6, C7, C8) in einer Ebene liegen.

4. Vielschichtbauelement nach einem der Ansprüche 1 oder 2, bei dem der zweite elektrische Gegenkontakt (80, 89) eines Vielschichtkondensators (C1, C2, C3, C4, C5, C6, C8) von beiden Stirnflächen (71, 72) her kontaktierbar ist.

5. Vielschichtbauelement nach einem der vorhergehenden Ansprüche, bei dem
- ein Stapel von Dielektrikumsschichten,
- ein im Grundkörper (1) angeordneter Stapel (51, 52, 53, 54) von übereinander liegenden Elektrodenschichten (4), die auf einer Seitenfläche (61, 62) des Vielschichtbauelements aus dem Grundkörper herausgeführt sind, und
- ein Stapel (50, 59) von Gegenelektrodenschichten, die auf einer Stirnfläche (71, 72) herausgeführt sind,
einen Vielschichtkondensator (C1, C2, C3, C4, C5, C6, C8)) bilden.

6. Vielschichtbauelement nach Anspruch 5, bei dem die Gegenelektrodenschichten (50) auf jeder Stirnseite (71, 72) aus dem Grundkörper (1) herausgeführt sind.

7. Vielschichtbauelement nach einem der vorhergehenden Ansprüche,
bei dem die Widerstandsstruktur (101, 102) erste Kontakte (81, 82, 83, 84) von Vielschichtkondensatoren (C1, C2, C3, C4, C5, C6, C8)) miteinander verbindet.

8. Vielschichtbauelement nach einem der vorhergehenden Ansprüche,
bei dem die Widerstandsstruktur (101, 102) im Innern des Grundkörpers (1) zwischen zwei Dielektrikumsschichten (3) angeordnet ist.

9. Vielschichtbauelement nach einem der vorhergehenden Ansprüche,
bei dem die Widerstandsstruktur (101, 102) auf der Oberfläche des Grundkörpers (1) angeordnet ist.

10. Vielschichtbauelement nach einem der vorhergehenden Ansprüche,
bei dem die Widerstandsstruktur (101, 102) hergestellt ist mittels einer Siebdruckpaste.

11. Vielschichtbauelement nach einem der vorhergehenden Ansprüche,
bei dem die Widerstandsstruktur (101, 102) RuO₂, Bi₂Ru₂O₇, C, Ti₂N oder LaB₆ enthält.

12. Vielschichtbauelement nach einem der vorhergehenden Ansprüche,
das mehrere Widerstandsstrukturen (101, 102) enthält, die gleich große oder verschieden große Widerstände (R1, R2) bilden.

13. Vielschichtbauelement nach einem der vorhergehenden Ansprüche,
bei dem die Widerstandsstruktur (101, 102) gegenüberliegende erste Kontakte (81, 82, 83, 84) verbindet.

14. Vielschichtbauelement nach einem der vorhergehenden Ansprüche,
bei dem die Widerstandsstruktur (101, 102) geradlinig verläuft.

15. Vielschichtbauelement nach einem der vorhergehenden Ansprüche,
bei dem die Widerstandsstruktur (101, 102) mäanderförmig verläuft.

16. Vielschichtbauelement nach einem der vorhergehenden Ansprüche,
bei dem entlang einer Seitenfläche (61, 62) angeordnete Vielschichtkondensatoren (C1 C3; C2, C4) die gleiche Kapazität aufweisen.

17. Vielschichtbauelement nach einem der vorhergehenden Ansprüche,
bei dem entlang einer Seitenfläche (61) angeordnete Vielschichtkondensatoren (C1 C3) eine größere Kapazität aufweisen, als entlang der gegenüberliegenden Seitenfläche (62) angeordnete Vielschichtkondensatoren (C2, C4).

18. Vielschichtbauelement nach einem der vorhergehenden Ansprüche,
bei dem die Kapazität von entlang einer Seitenfläche (61) angeordneten Vielschichtkondensatoren (C1 C3, C5, C7) in Längsrichtung des Grundkörpers (1) monoton steigt oder fällt.

19. Vielschichtbauelement nach einem der vorhergehenden Ansprüche,
bei dem die Dielektrikumsschichten (3) ein Keramikmaterial mit Varistoreffekt enthalten.

20. Vielschichtbauelement nach Anspruch 19,
bei dem die Dielektrikumsschichten (3) ZnO-Bi oder ZnO-Pr enthalten.

21. Vielschichtbauelement nach einem der vorhergehenden Ansprüche,
bei dem die Dielektrikumsschichten (3) eine Kondensatorkeramik auf der Basis von Bariumtitanat enthalten.

22. Vielschichtbauelement nach einem der vorhergehenden Ansprüche,
bei dem der Grundkörper (1) eine Grundfläche (A) aufweist, die kleiner ist als 2,5 mm² und der mindestens vier Vielschichtkondensatoren und mindestens zwei Widerstandsstrukturen (101, 102) enthält.

23. Vielschichtbauelement nach einem der vorhergehenden Ansprüche,
bei dem der Grundkörper (1) eine Grundfläche (A) aufweist, die kleiner als 5,2 mm² ist und der mindestens acht Vielschichtkondensatoren und mindestens vier Widerstandsstrukturen (101, 102) enthält.

24. Vielschichtbauelement nach einem der vorhergehenden Ansprüche,
bei dem der Grundkörper (1) eine Grundfläche (A) aufweist, die kleiner als 8 mm² ist und der mindestens acht, zehn oder zwölf Vielschichtkondensatoren und mindestens vier Widerstandsstrukturen (101, 102) enthält.

25. Vielschichtbauelement nach einem der vorhergehenden Ansprüche,
bei dem die Elektrodenschichten (4) zumindest eines der folgenden Materialien enthalten: Ag, Pd, Pt, Cu, Ni, eine Legierung aus Ag und Pd, eine Legierung aus Ag und Pt.

26. Vielschichtbauelement nach einem der vorhergehenden Ansprüche, bei dem
- zwei Paare von jeweils gegenüberliegenden Vielschichtkondensatoren (C1 C2; C3, C4) mit jeweils einer Widerstandsstruktur (101, 102) zwei n-Filter bilden, und
- die Dielektrikumsschichten (3) eine Varistorkeramik enthalten.

27. Schaltungsanordnung, enthaltend ein Vielschichtbauelement nach einem der vorhergehenden Ansprüche,
mit einem Gerät (11), das wenigstens zwei Zuleitungen (12, 13) aufweist, die so mit einem Vielschichtbauelement nach Anspruch 26 verbunden sind, daß jede Zuleitung (12, 13) an ein Π-Filter angeschlossen ist zur Ableitung hochfrequenter Störungen zu einer an einer Stirnfläche (71, 72) des Vielschichtbauelements (10) anschließbaren Erde.

## Claims

1. Multilayer component
- comprising a base body (1) containing a stack (2) composed of dielectric layers (3) lying one above another with electrode layers (4) lying in between,
- in which the base body (1) has, running along a longitudinal direction, opposite side faces (61, 62) and end faces (71, 72),
- into which a resistance structure (101, 102) is integrated,
- comprising a plurality of multilayer capacitors (C1, C2, C3, C4, C5, C6, C7, C8), wherein
- a first electrical contact (81) of each multilayer capacitor is arranged on a side face (61) of the multilayer component, and
- a second electrical counter-contact (80) of each multilayer capacitor is arranged on an end face (71, 72) of the multilayer component, and
- the first electrical contacts of at least two multilayer capacitors are arranged on opposite side faces, and
- each multilayer capacitor has a plurality of electrode layers which are arranged one above another and are contact-connected with its first electrical contact,
- at least two of the multilayer capacitors are arranged alongside one another in a longitudinal direction.

2. Multilayer component according to Claim 1, in which at least two of the multilayer capacitors (C1, C2, C3, C4, C5, C6, C7, C8) are opposite one another in a transverse direction.

3. Multilayer component according to either of Claims 1 and 2, in which the electrode layers (4) of adjacent multilayer capacitors (C1, C2, C3, C4, C5, C6, C7, C8) lie in one plane.

4. Multilayer component according to either of Claims 1 and 2, in which the second electrical counter-contact (80, 89) of a multilayer capacitor (C1, C2, C3, C4, C5, C6, C8) can be contact-connected from both end faces (71, 72).

5. Multilayer component according to one of the preceding claims, in which
- a stack of dielectric layers,
- a stack (51, 52, 53, 54) - which is arranged in the base body (1) - of electrode layers (4) which lie one above another and which are led out from the base body on a side face (61, 62) of the multilayer component, and
- a stack (50, 59) of counter-electrode layers which are led out on an end face (71, 72)
form a multilayer capacitor (C1, C2, C3, C4, C5, C6, C8).

6. Multilayer component according to Claim 5, in which the counter-electrode layers (50) are lead out from the base body (1) on each end side (71, 72).

7. Multilayer component according to one of the preceding claims,
in which the resistance structure (101, 102) connects first contacts (81, 82, 83, 84) of multilayer capacitors (C1, C2, C3, C4, C5, C6, C8) to one another.

8. Multilayer component according to one of the preceding claims,
in which the resistance structure (101, 102) is arranged in the interior of the base body (1) between two dielectric layers (3).

9. Multilayer component according to one of the preceding claims,
in which the resistance structure (101, 102) is arranged on the surface of the base body (1).

10. Multilayer component according to one of the preceding claims,
in which the resistance structure (101, 102) is produced by means of a screen printing post.

11. Multilayer component according to one of the preceding claims,
in which the resistance structure (101, 102) contains RuO₂, Bi₂Ru₂O₇, C, Ti₂N or LaB₆.

12. Multilayer component according to one of the preceding claims,
which contains a plurality of resistance structures (101, 102) which form identically sized or differently sized resistors (R1, R2).

13. Multilayer component according to one of the preceding claims,
in which the resistance structure (101, 102) connects opposite first contacts (81, 82, 83, 84).

14. Multilayer component according to one of the preceding claims,
in which the resistance structure (101, 102) runs in rectilinear fashion.

15. Multilayer component according to one of the preceding claims,
in which the resistance structure (101, 102) runs in meandering fashion.

16. Multilayer component according to one of the preceding claims,
in which multilayer capacitors (C1, C3; C2, C4) arranged along a side face (61, 62) have the same capacitance.

17. Multilayer component according to one of the preceding claims,
in which multilayer capacitors (C1, C3) arranged along a side face (61) have a larger capacitance than multilayer capacitors (C2, C4) arranged along the opposite side face (62).

18. Multilayer component according to one of the preceding claims,
in which the capacitance of multilayer capacitors (C1, C3, C5, C7) arranged along a side face (61) rises or falls monotonically in a longitudinal direction of the base body (1).

19. Multilayer component according to one of the preceding claims,
in which the dielectric layers (3) contain a ceramic material with a varistor effect.

20. Multilayer component according to Claim 19,
in which the dielectric layers (3) contain ZnO-Bi or ZnO-Pr.

21. Multilayer component according to one of the preceding claims,
in which the dielectric layers (3) contain a capacitor ceramic based on barium titanate.

22. Multilayer component according to one of the preceding claims,
in which the base body (1) has a base area (A) which is less than 2.5 mm² and contains at least four multilayer capacitors and at least two resistance structures (101, 102).

23. Multilayer component according to one of the preceding claims,
in which the base body (1) has a base area (A) which is less than 5.2 mm² and contains at least 8 multilayer capacitors and at least 4 resistance structures (101, 102).

24. Multilayer component according to one of the preceding claims,
in which the base body (1) has a base area (A) which is less than 8 mm² and contains at least 8, 10 or 12 multilayer capacitors and at least 4 resistance structures (101, 102).

25. Multilayer component according to one of the preceding claims,
in which the electrode layers (4) contain at least one of the following materials: Ag, Pd, Pt, Cu, Ni, an alloy of Ag and Pd, an alloy of Ag and Pt.

26. Multilayer component according to one of the preceding claims, in which
- two pairs of respectively opposite multilayer capacitors (C1, C2; C3, C4) together with a respective resistance structure (101, 102) form two Π filters, and
- the dielectric layers (3) contain a varistor ceramic.

27. Circuit arrangement containing a multilayer component according to one of the preceding claims,
comprising a device (11) having at least two leads (12, 13) which are connected to a multilayer component according to Claim 26 in such a way that each lead (12, 13) is connected to a Π filter for conducting away highfrequency interference to an earth that can be connected to an end face (71, 72) of the multilayer component (10).

## Revendications

1. Composant multicouche
- avec un corps de base (1) contenant une pile (2) constituée de couches formant diélectriques superposées (3) avec des couches formant électrodes (4) intercalées,
- tel que le corps de base (1) comporte des surfaces latérales (61, 62) opposées et s'étendant le long d'une direction longitudinale et des surfaces frontales (71, 72),
- dans lequel une structure de résistance (101, 102) est intégrée,
- avec plusieurs condensateurs multicouches (C1, C2, C3, C4, C5, C6, C7, C8),
- un premier contact électrique (81) de chaque condensateur multicouche étant disposé sur une surface latérale (61) du composant multicouche, et
- un deuxième contre-contact électrique (80) de chaque condensateur multicouche étant disposé sur une surface frontale (71, 72) du composant multicouche, et
- les premiers contacts électriques d'au moins deux condensateurs multicouches étant disposés sur des surfaces latérales opposées, et
- chaque condensateur multicouche comportant plusieurs couches formant électrodes superposées mises en contact avec son premier contact électrique, et
- au moins deux des condensateurs multicouches étant disposés l'un à côté de l'autre dans la direction longitudinale.

2. Composant multicouche selon la revendication 1, dans lequel au moins deux des condensateurs multicouches (C1, C2, C3, C4, C5, C6, C7, C8) se font face dans la direction transversale.

3. Composant multicouche selon l'une des revendications 1 ou 2, dans lequel les couches formant électrodes (4) de condensateurs multicouches (C1, C2, C3, C4, C5, C6, C7, C8) voisins se trouvent dans un plan.

4. Composant multicouche selon l'une des revendications 1 ou 2, dans lequel le deuxième contre-contact électrique (80, 89) d'un condensateur multicouche (C1, C2, C3, C4, C5, C6, C8) peut être mis en contact à partir des deux surfaces frontales (71, 72).

5. Composant multicouche selon l'une des revendications précédentes, dans lequel
- une pile de couches formant diélectriques,
- une pile (51, 52, 53, 54), disposée dans le corps de base (1), de couches formant électrodes superposées (4) qui sortent du corps de base sur une surface latérale (61, 62) du composant multicouche, et
- une pile (50, 59) de couches formant contre-électrodes qui sortent sur une surface frontale (71, 72),
forment un condensateur multicouche (C1, C2, C3, C4, C5, C6, C8).

6. Composant multicouche selon la revendication 5, dans lequel les couches formant contre-électrodes (50) sortent du corps de base (1) sur chaque surface frontale (71, 72).

7. Composant multicouche selon l'une des revendications précédentes, dans lequel la structure de résistance (101, 102) relie entre eux des premiers contacts (81, 82, 83, 84) de condensateurs multicouches (C1, C2, C3, C4, C5, C6, C8).

8. Composant multicouche selon l'une des revendications précédentes, dans lequel la structure de résistance (101, 102) est disposée à l'intérieur du corps de base (1) entre deux couches formant diélectriques (3).

9. Composant multicouche selon l'une des revendications précédentes, dans lequel la structure de résistance (101, 102) est disposée sur la surface du corps de base (1).

10. Composant multicouche selon l'une des revendications précédentes, dans lequel la structure de résistance (101, 102) est fabriquée au moyen d'une pâte de sérigraphie.

11. Composant multicouche selon l'une des revendications précédentes, dans lequel la structure de résistance (101, 102) contient RuO₂, Bi₂Ru₂O₇, C, Ti₂N ou LaB₆.

12. Composant multicouche selon l'une des revendications précédentes, qui contient plusieurs structures de résistance (101, 102) qui forment des résistances (R1, R2) de grandeur identique ou de grandeur différente.

13. Composant multicouche selon l'une des revendications précédentes, dans lequel la structure de résistance (101, 102) relie des premiers contacts opposés (81, 82, 83, 84).

14. Composant multicouche selon l'une des revendications précédentes, dans lequel la structure de résistance (101, 102) s'étend en ligne droite.

15. Composant multicouche selon l'une des revendications précédentes, dans lequel la structure de résistance (101, 102) s'étend en forme de méandres.

16. Composant multicouche selon l'une des revendications précédentes, dans lequel des condensateurs multicouches (C1, C3 ; C2, C4) disposés le long d'une surface latérale (61, 62) ont la même capacité.

17. Composant multicouche selon l'une des revendications précédentes, dans lequel des condensateurs multicouches (C1, C3) disposés le long d'une surface latérale (61) ont une plus grande capacité que des condensateurs multicouches (C2, C4) disposés le long de la surface latérale opposée (62).

18. Composant multicouche selon l'une des revendications précédentes, dans lequel la capacité de condensateurs multicouches (C1, C3, C5, C7) disposés le long d'une surface latérale (61) augmente ou diminue de façon monotone dans la direction longitudinale du corps de base (1).

19. Composant multicouche selon l'une des revendications précédentes, dans lequel les couches formant diélectriques (3) contiennent un matériau céramique avec effet de varistor.

20. Composant multicouche selon la revendication 19, dans lequel les couches formant diélectriques (3) contiennent ZnO-Bi ou ZnO-Pr.

21. Composant multicouche selon l'une des revendications précédentes, dans lequel les couches formant diélectriques (3) contiennent une céramique de condensateur sur la base du titanate de baryum.

22. Composant multicouche selon l'une des revendications précédentes, dans lequel le corps de base (1) comporte une surface de base (A) qui est inférieure à 2,5 mm² et qui contient au moins quatre condensateurs multicouches et au moins deux structures de résistance (101, 102).

23. Composant multicouche selon l'une des revendications précédentes, dans lequel le corps de base (1) comporte une surface de base (A) qui est inférieure à 5,2 mm² et qui contient au moins huit condensateurs multicouches et au moins deux structures de résistance (101, 102).

24. Composant multicouche selon l'une des revendications précédentes, dans lequel le corps de base (1) comporte une surface de base (A) qui est inférieure à 8 mm² et qui contient au moins huit, dix ou douze condensateurs multicouches et au moins quatre structures de résistance (101, 102).

25. Composant multicouche selon l'une des revendications précédentes, dans lequel les couches formant électrodes (4) contiennent au moins l'un des matériaux suivants : Ag, Pd, Pt, Cu, Ni, un alliage de Ag et Pd, un alliage de Ag et Pt.

26. Composant multicouche selon l'une des revendications précédentes, dans lequel
- deux paires de condensateurs multicouches respectivement opposés (C1, C2 ; C3, C4) avec à chaque fois une structure de résistance (101, 102) forment deux filtres Π, et
- les couches formant diélectriques (3) contiennent une céramique de varistor.

27. Circuit, contenant un composant multicouche selon l'une des revendications précédentes, avec un appareil (11) qui comporte au moins deux lignes d'amenée (12, 13) qui sont reliées de telle sorte à un composant multicouche selon la revendication 26 que chaque ligne d'amenée (12, 13) est raccordée à un filtre Π pour la dérivation de parasites à haute fréquence vers une terre pouvant être raccordée à une surface frontale (71, 72) du composant multicouche (10).
